# DEMANDE DE BREVET EUROPEEN

(11) **EP 3 495 916 A1**
(43) Date de publication de la demande: **12.06.2019**
(21) Numéro de dépôt: 18210558.5
(22) Date de dépôt: 05.12.2018
(51) Int. Cl.: G06F 1/18, G06F 13/40, H05K 7/14

(54) **ORDINATEUR, DONT L'UNITÉ CENTRALE EST DOTÉE D'UNE EMBASE DE TYPE MINI SAS HD POUR UNE CONNEXION À UNE CARTE D'EXTENSION**

(30) Priorité: 08.12.2017 FR 1761823
(71) Demandeur: Ecrin Systems, 38920 Crolles (FR)
(72) Inventeur: AUPETIT, Frédéric, 38920 Crolles (FR)
(74) Mandataire: GIE Innovation Competence Group

(57) **Abrégé**

Un objet de l'invention est un ordinateur contenu dans un châssis (2), et comportant une unité centrale (10) et une carte d'extension (31), distante de l'unité centrale, l'ordinateur étant tel que
- l'unité centrale (10) et la carte d'extension sont logées dans le châssis ;
- la carte d'extension est configurée pour assurer une interface avec un élément distant (50), situé hors du châssis (2), de façon à adresser un signal de commande à l'élément distant et/ou à acquérir un signal généré par l'élément distant ;
- l'unité centrale (10) comporte une carte porteuse (12) et une carte mère (11), reliées l'une à l'autre, la carte mère comprenant un microprocesseur (13), la carte porteuse (12) assurant une interface entre la carte mère et au moins un port d'entrée/sortie (102), disposé dans l'unité centrale, et destiné à être raccordés à la carte d'extension (31) ;
l'ordinateur étant caractérisé en ce que :
- la carte porteuse comporte une embase de type Mini SAS HD (102), formant un port d'entrée/sortie de l'unité centrale (10), la carte porteuse (12) définissant un routage entre l'embase Mini SAS HD et le microprocesseur (13) de la carte mère, de façon à autoriser une communication entre le microprocesseur et la carte d'extension (31), à travers l'embase Mini SAS HD, selon un protocole PCI Express ;
- l'unité centrale (10) est reliée à la carte d'extension (31) par un câble de connexion (5), le câble de connexion étant souple et comportant une extrémité comprenant un connecteur de type Mini SAS HD, raccordé à l'embase Mini SAS HD de l'unité centrale.

## Description

### DOMAINE TECHNIQUE

Le domaine technique de l'invention est la conception d'une unité centrale d'ordinateur, en particulier pour un ordinateur dédié à des applications professionnelles, par exemple dans le domaine industriel, militaire ou le transport.

### ART ANTERIEUR

Dans le domaine de l'informatique industrielle, des ordinateurs présentent une ou plusieurs unité(s) centrale (s), ces dernières étant connectées à des moyens de stockage, ainsi qu'à des cartes d'extension, usuellement désignées par le terme carte I/O, acronyme de l'anglais "Input and Output". D'une façon générale, une carte d'extension est destinée à être reliée à un capteur ou à un actionneur. Lorsqu'elle est reliée à un capteur, la carte d'extension permet l'acquisition d'un signal physique acquis par le capteur. Lorsqu'elle est reliée à un actionneur, la carte d'extension permet un pilotage de ce dernier par un signal de commande, émis par l'unité centrale. D'une façon générale, une carte d'extension assure l'interface entre l'unité centrale et un élément distant, de type capteur ou actionneur.

La communication entre l'unité centrale et une carte I/O est fréquemment mise en oeuvre par un bus, notamment un bus de type PCI express, selon le protocole PCI express (PCIe), et en particulier le protocole PCI express - Génération 3, désigné par l'acronyme PCIe-Gen3. L'acronyme PCI, désignant "Peripheral Component Interconnect" est connu de l'homme du métier.

Une unité centrale peut également être reliée à des moyens périphériques de stockage, la communication étant effectuée selon différents protocoles, par exemple le protocole SATA (Serial ATA), le protocole SAS (Serial Attached SCSI). Suivant le développement du protocole SAS 3, autorisant des débits de 12 Gb/s, des connecteurs compacts de type Mini SAS-HD ont été proposés, la connexion de type Mini SAS HD suivant les spécifications SFF-8643 et/ou SFF-8644. Ces connecteurs sont particulièrement compacts, et autorisent une transmission d'informations à haut débit. Par ailleurs, le standard NVMe (Non Volatile Memory express) permet à une unité centrale d'accéder à un périphérique de stockage à travers un bus PCIe. Des utilisations de connecteurs de type mini SAS HD, pour relier une unité centrale à des périphériques de stockage, sont par exemple décrites dans US9653124, US2017/0177222, ainsi que dans US2017/0147254, US2017/0153660 ou US2017/0150621.

Les unités centrales équipant les ordinateurs industriels doivent être aptes à être connectées à de multiples cartes d'extension I/O, ainsi qu'à des périphériques de stockage. En outre, elles doivent être compactes, de façon à être logées dans des châssis de dimensions normalisées. Les châssis sont souvent des châssis dits "19 pouces" selon la norme IEC 60297. Ils sont destinés à être intégrés dans des baies au standard 19 pouces. La hauteur des châssis est également normalisée. Elle est usuellement exprimée en multiples de U, ou U désigne une hauteur normalisée de 44,45 mm. On trouve ainsi des châssis 1U, 2U, 3U...Dans un environnement aussi contraint, une difficulté se pose lorsque plusieurs cartes d'acquisition doivent être connectées à une même unité centrale, et cette difficulté est d'autant plus prégnante que les dimensions du châssis sont limitées, notamment selon la hauteur.

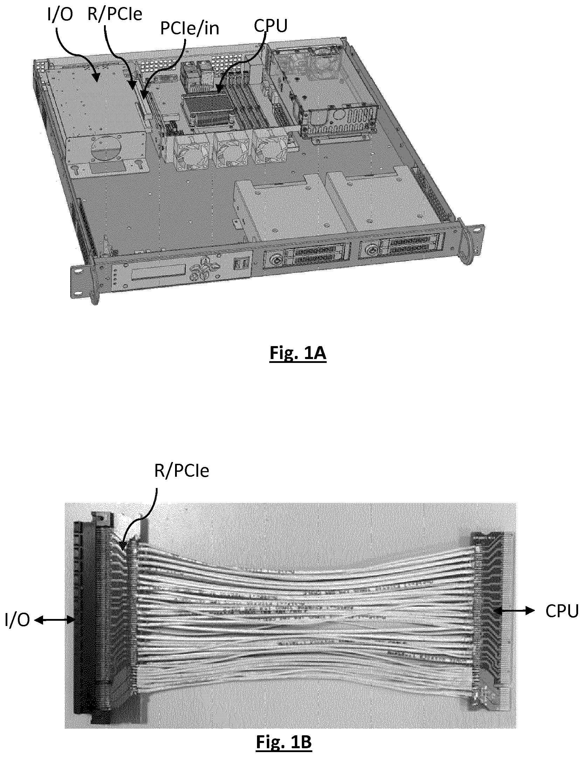

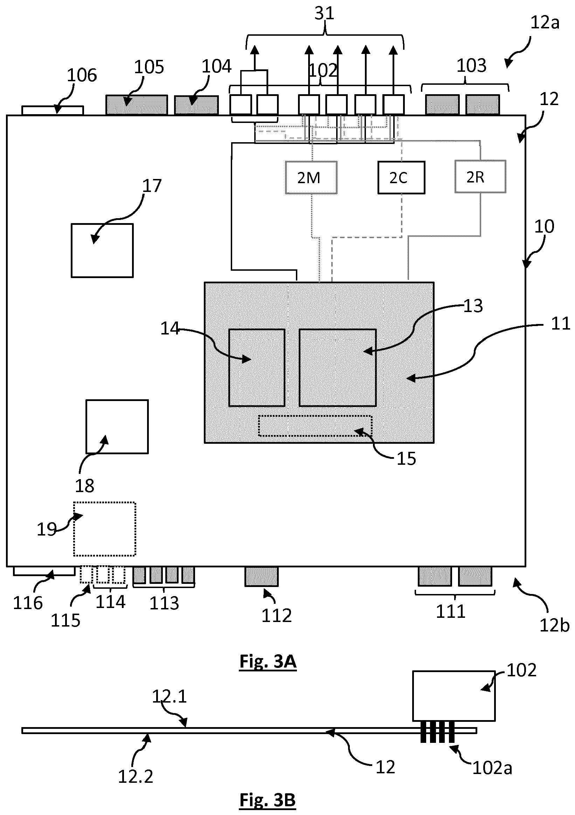

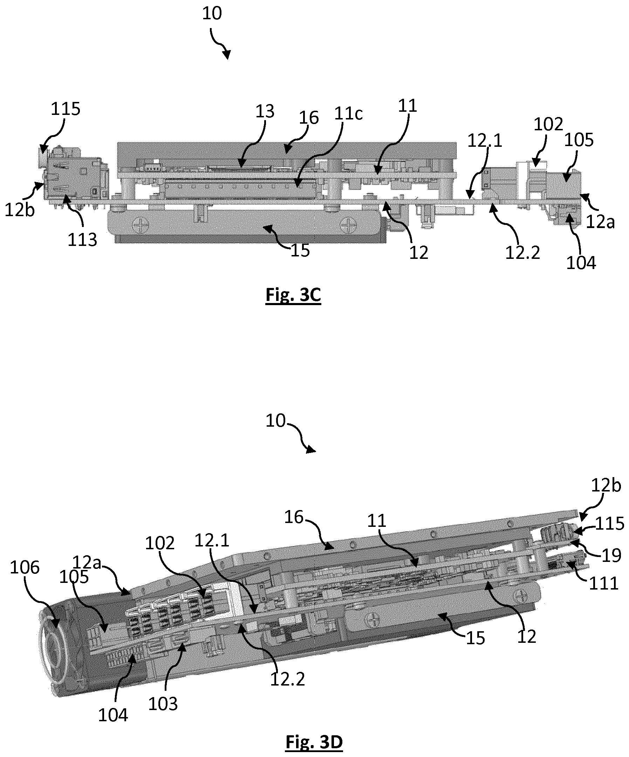

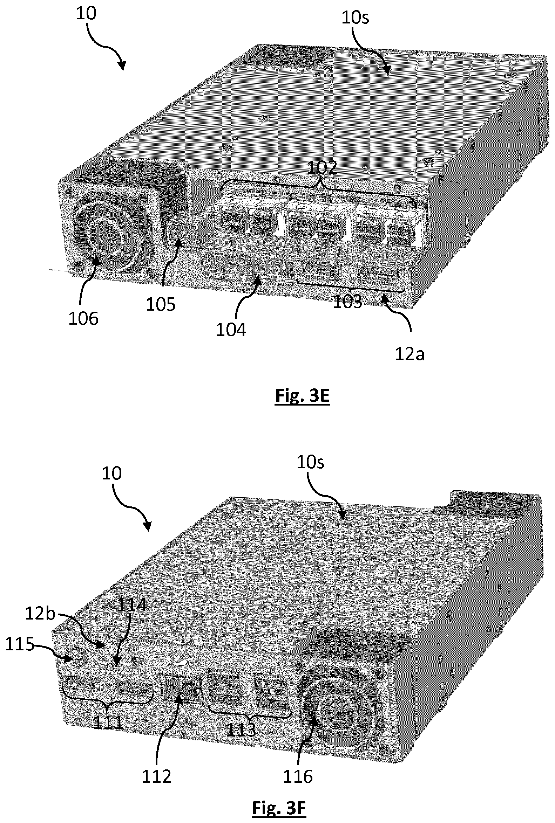

La figure 1A représente un châssis de type 1U, dans lequel est disposée une unité centrale CPU au format standard mini-ITX (Information Technology Extended). De façon usuelle, les unités centrales comportent des ports (ou "slots") PCIe, de type PCIe 16x, PCIe 8x ou PCIe 4x, se présentant sous la forme d'embases femelles longilignes, dites slots (fentes) ou embases linéaires PCIe. Sur la figure 1A, la référence PCIe/in désigne une des embases disponibles sur l'unité centrale. Des ports PCIe/in sont ménagés selon la hauteur de l'unité centrale, et accessibles depuis l'extérieur de cette dernière. Chacun d'entre eux peut être raccordé à une carte d'extension I/O en utilisant une connexion souple de type Riser PCIe telle que représentée sur la figure 1A sous la référence R/PCIe. Une telle connexion est également représentée sur la figure 1B. Elle comporte une nappe flexible, permettant un raccordement entre une unité centrale CPU et une carte d'extension I/O. On comprend que le nombre de connexions est limité par le nombre de ports PCIe accessibles depuis l'extérieur de l'unité centrale. Par ailleurs, une connexion par riser PCIe n'est satisfaisante que lorsque la carte périphérique I/O est adjacente de l'unité centrale, ou suffisamment proche de cette dernière. Ainsi, non seulement le nombre de cartes d'extension I/O est limité, mais leur emplacement est lié à la position de l'unité centrale dans le châssis. Le document US2016/0147699 décrit un exemple d'utilisation d'une telle nappe flexible, comme le montre la figure 3 dudit document.

Le document US2015/0003004 décrit une carte mère perpendiculairement à laquelle on a disposé une carte d'interface. La carte d'interface assure une interface entre une connexion classique PCIe, disposée sur la carte mère, et des ports USB.

L'inventeur a souhaité disposer de davantage de versatilité dans la conception d'ordinateurs professionnels. Plus précisément, il a recherché une solution lui permettant d'augmenter le nombre de cartes d'extensions connectables à une même unité centrale, tout en présentant une plus grande souplesse quant à la position de ces cartes par rapport à l'unité centrale. C'est l'objet de l'invention décrite ci-après.

### EXPOSE DE L'INVENTION

Un premier objet de l'invention est un ordinateur, contenu dans un châssis, et comportant une unité centrale ainsi qu'au moins une carte d'extension, distante de l'unité centrale, l'ordinateur étant tel que :
- l'unité centrale et la carte d'extension sont logées dans le châssis ;
- la carte d'extension est configurée pour assurer une interface avec un élément distant, situé hors du châssis, de façon à adresser un signal de commande à l'élément distant et/ou à acquérir un signal généré par l'élément distant ;
- l'unité centrale comporte une carte porteuse et une carte mère, reliées l'une à l'autre, la carte mère comprenant un microprocesseur, la carte porteuse assurant une interface entre la carte mère et au moins un port d'entrée/sortie, disposé dans l'unité centrale, et destiné à être raccordé à la carte d'extension ;
l'ordinateur étant caractérisé en ce que :
- la carte porteuse comporte une embase de type Mini SAS HD, formant un port d'entrée/sortie de l'unité centrale, la carte porteuse définissant un routage entre l'embase Mini SAS HD et le microprocesseur de la carte mère, de façon à autoriser une communication entre le microprocesseur et la carte d'extension, à travers l'embase Mini SAS HD, selon un protocole PCI Express ;
- l'unité centrale est reliée à la carte d'extension par un câble de connexion, le câble de connexion étant souple et comportant une extrémité formant un connecteur de type Mini SAS HD, raccordé à l'embase Mini SAS HD de la carte porteuse.

Les termes "une" ou "un" s'entendent comme signifiant "au moins une" ou "au moins un".

La carte porteuse et la carte mère peuvent s'étendre l'une parallèlement à l'autre. Elles peuvent être reliées l'une à l'autre par un connecteur, par exemple un connecteur de type COM Express.

Le protocole PCI Express peut notamment être un protocole de type PCI Express Génération 3 ou PCI Express Génération 4.

La carte porteuse peut s'étendre selon un support rigide, par exemple une plaque rigide, l'embase Mini SAS HD étant disposée à travers le support rigide. Selon un mode de réalisation, l'embase Mini SAS HD présente des broches de connexions, ces dernières s'étendant à travers le support rigide, en étant notamment fixés à ce dernier, par exemple par sertissage ou soudure.

La carte porteuse peut comporter une pluralité d'embases de type Mini SAS HD. La carte porteuse comporte alors un multiplexeur d'adressage, relié d'une part au microprocesseur de la carte mère et d'autre part aux embases Mini SAS HD. Elle peut également comporter un multiplicateur de signal d'horloge, relié d'une part au microprocesseur de la carte mère et d'autre part aux embases Mini SAS HD. La carte porteuse peut également comporter un multiplicateur de signal d'initialisation, relié d'une part au microprocesseur de la carte mère et d'autre part à plusieurs embases Mini SAS HD.

La carte porteuse peut être apte à diriger un signal de réveil, provenant de la carte d'extension, à destination du microprocesseur de la carte mère. Le signal de réveil est dirigé entre au moins une embase Mini SAS HD et la carte mère de l'unité centrale. Le signal de réveil permet d'activer le microprocesseur lorsqu'un signal de réveil est émis par l'élément distant. Il se propage de la carte d'extension vers l'unité centrale. L'élément distant, relié à la carte d'extension peut être choisi parmi :
- un capteur, configuré pour acquérir un signal, de telle sorte que la carte d'extension forme une carte d'acquisition du signal ;
- ou un actionneur, configuré pour effectuer une action pilotée par le microprocesseur ;

Selon un mode de réalisation, l'unité centrale comporte un ventilateur, apte à propager un flux d'air à travers l'unité centrale, cette dernière comportant également un radiateur en forme de plaque, s'étendant parallèlement à la carte mère, de façon à conduire une chaleur dégagée par cette dernière vers le flux d'air.

De préférence, l'unité centrale s'étend à l'intérieur d'un module de type 5 pouces % selon la spécification SFF-8500.

La carte d'extension peut notamment être disposée dans un module d'extension, ce dernier comportant une interface de connexion, comportant d'une part une embase Mini SAS-HD, configurée pour recevoir un connecteur mini SAS-HD du câble de connexion, et d'autre part une embase PCIe linéaire, dans lequel la carte d'extension est apte à être insérée. Le câble souple reliant l'unité centrale au module d'extension comporte de préférence un connecteur mini SAS-HD à chacune de ses extrémités.

Le châssis de l'ordinateur peut notamment être un châssis de type 19 pouces, selon la spécification IEC-60297, la hauteur étant *n*U, U désignant une hauteur normalisée de 44.45 mm, *n* étant un entier supérieur ou égal à 1. En général, la hauteur s'étend entre 1U et 4U.

D'autres avantages et caractéristiques ressortiront plus clairement de la description qui va suivre de modes particuliers de réalisation de l'invention, donnés à titre d'exemples non limitatifs, et représentés sur les figures listées ci-dessous.

### FIGURES

La figure 1A illustre un ordinateur selon l'art antérieur. La figure 1B est une photographie d'une nappe flexible permettant une connexion entre un port PCIe, débouchant d'une unité centrale de l'art antérieur, avec une carte d'extension.
Les figures 2A et 2B illustrent des configurations d'un ordinateur selon l'invention. La figure 2C représente une interface de connexion, pour raccorder une carte d'extension, disposant d'une embase linéaire PCIe, avec un câble disposant d'un connecteur de type mini SAS HD.
La figure 3A schématise les principaux composants et ports d'entrée/sortie d'une unité centrale selon l'invention. La figure 3B montre l'implantation d'une embase de type mini SAS HD sur la carte porteuse de l'unité centrale. Les figures 3C, 3D, 3E et 3F sont des représentations de l'unité centrale schématisée sur la figure 3A.
Les figures 4A et 4B montrent des ordinateurs comportant une unité centrale telle que décrite en lien avec les figures 3A à 3F.

### EXPOSE DE MODES DE REALISATION PARTICULIERS

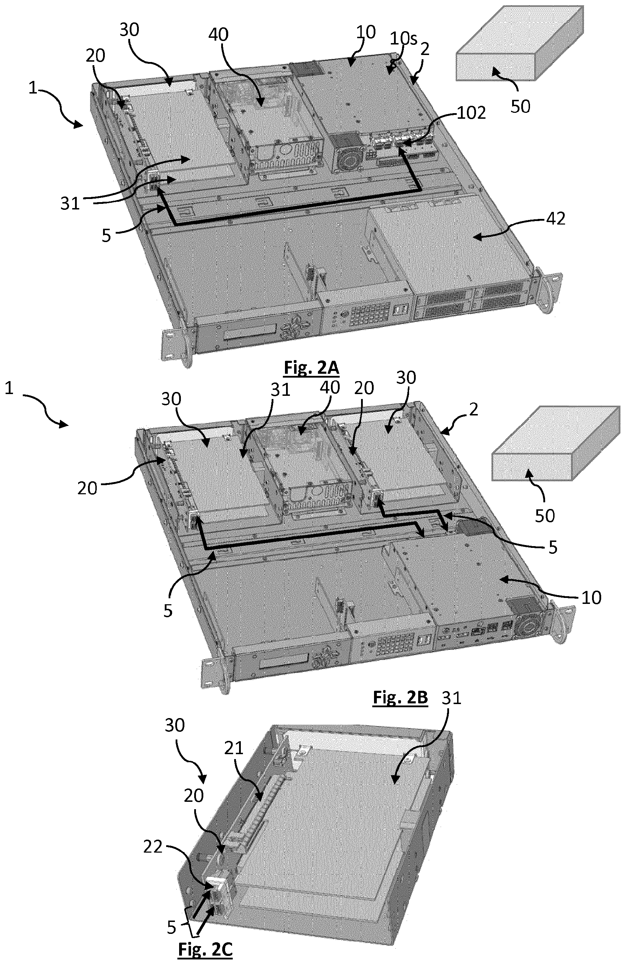

La figure 2A représente un ordinateur industriel 1 comportant un châssis 2 de dimensions 19 pouces, selon la norme IEC 60297, de hauteur 1U. Le châssis comporte une unité centrale (CPU), 10 ainsi qu'un module I/O 30 comportant deux cartes d'extension I/O 31. L'unité centrale 10 est comprise dans un module 10s de dimensions normalisées 5"1/4. L'ordinateur 1 comporte ici un périphérique de stockage de données 42 et un module d'alimentation 40. On distingue la face arrière de l'unité centrale 10, de laquelle comporte six connexions de type mini SAS-HD référencées 102.

Contrairement à l'art antérieur, selon lequel les ports mini SAS-HD sont dédiés à des connexions avec des périphériques de stockage, l'invention met en oeuvre les ports mini SAS HD 102 pour assurer une interface avec les cartes d'extension 31. Cela permet une connexion, par un câble de connexion 5, entre les ports mini SAS HD de l'unité centrale 10 et chaque carte d'extension 31. La connexion est simplifiée par rapport à une nappe souple de type riser PCIe. Le fait de disposer d'une connexion par un câble de connexion souple 5 confère une plus grande liberté dans la disposition des cartes d'extension 31 par rapport à l'unité centrale 10. La carte d'extension 31 peut être reliée à un élément distant 50, de façon à contrôler ce dernier et/ou acquérir des signaux captés par ce dernier. Le câble de connexion 5 est de préférence un câble de géométrie cylindrique, et en particulier cylindrique de révolution.

L'élément distant 50 est un élément contrôlé par un microprocesseur 13 de l'unité centrale 10, décrit ultérieurement en lien avec la figure 3A, par l'intermédiaire de la carte d'acquisition 31 à laquelle il est relié. Il peut notamment s'agir :
- d'un capteur, configuré pour acquérir un signal, de telle sorte que la carte d'extension forme une carte d'acquisition du signal. Il peut par exemple s'agir d'une caméra, d'un capteur acoustique ou électrique, ou, d'une façon générale, d'un transducteur formant un signal électrique à partir d'un paramètre physique détecté.
- et/ou d'un actionneur, configuré pour effectuer une action pilotée par le microprocesseur 13 de l'unité centrale 10. Il peut s'agir d'un élément asservi par le microprocesseur, par exemple une électrovanne, un buzzer, un moteur, ou, d'une façon plus générale, de tout actionneur générant un signal ou une action physique à partir d'une instruction transmise par le microprocesseur.

Un autre avantage lié à l'utilisation d'un port de type mini SAS HD est la compacité, ce qui permet de disposer plusieurs ports mini SAS HD les uns à côté des autres, dans un faible encombrement. L'unité centrale 10 représentée sur la figure 2A, comporte six ports mini SAS HD 102. En outre, le coût des connecteurs mini SAS HD est faible, et ces derniers sont largement répandus, sans être dépendants d'un fabricant particulier. En termes de débit, les ports mini SAS-HD peuvent supporter des débits de 12 Gbits/s, compatibles avec la norme PCIe-Gen3.

La figure 2B représente une autre configuration selon laquelle on dispose de deux modules d'extension 30, dans le châssis 2, avec deux cartes d'extension 31 par module, les deux modules 30 étant distants l'un de l'autre. On observe que contrairement à la configuration illustrée sur la figure 1A, la connexion par câble, par l'intermédiaire des ports mini SAS-HD, permet de disposer l'unité centrale 10 à distance des modules d'extension 30. Par module d'extension, on entend un élément permettant l'insertion d'une ou plusieurs cartes d'extension 31.

La figure 2C détaille l'insertion d'une carte d'extension 31 dans un module d'extension 30. Le module d'extension 30 comporte une carte d'interconnexion rigide, dite "carte de fond de panier" 20, assurant l'interface entre, d'une part, une ou plusieurs embases femelles Mini SAS HD 22 et, d'autre part, une embase linéaire PCIe 21. Ainsi, une carte d'extension I/O peut être raccordée, par un connecteur linéaire PCIe, dans l'embase PCIe 21 de la carte 20. Chaque embase Mini SAS HD 22 est destinée à être reliée, par une connexion filaire, à un port Mini SAS HD 102 de l'unité centrale 10. La carte 20 permet une adaptation entre une connexion Mini SAS HD, régie par la spécification SFF-8643, avec une embase PCIe. Par embase, on entend un connecteur fixe, notamment de type femelle, destiné à être raccordé au connecteur, notamment de type mâle, d'un câble de connexion ou d'une carte d'extension.

Les figures 3A à 3F sont des illustrations d'une unité centrale 10 selon l'invention. L'unité centrale 10 comporte une carte mère 11 et une carte porteuse 12, la carte mère étant disposée face à une première face 12.1 de la carte porteuse 12. La carte mère 11 comporte un microprocesseur 13 et une mémoire 14. Un support de stockage de données 15 est disposé face à une deuxième face 12.2 de la carte porteuse, opposée à la première face 12.1, comme illustré sur la figure 3C. La liaison entre le support de stockage 15 et la carte mère est réalisée au moyen d'un connecteur coudé SATA. Afin d'optimiser la compacité, la carte mère 11 et la carte porteuse 12 s'étendent parallèlement l'une à l'autre.

La carte mère 11 est reliée à la carte porteuse 12 par une connexion de type COM Express de type 6. Pour cela, la carte mère 11 comporte un connecteur 11c COM Express mâle, s'insérant dans une embase de type COM express portée par la carte porteuse 12. La carte porteuse 12 assure un routage entre la carte mère 11 et différentes embases de connexion, formant des ports d'entrée/sortie, débouchant d'une partie arrière 12a ou d'une partie avant 12b de la carte porteuse 12. Un aspect important de l'invention est que la carte porteuse 12 assure un routage entre le microprocesseur 13 de la carte mère 11 et les ports mini SAS HD 102, de façon à permettre une communication avec des cartes d'extension 31 situées dans le châssis 2, selon le protocole PCIe. Ainsi, la carte porteuse 12 assure une fonction d'interconnexion entre la carte mère 11 et les ports mini SAS HD 102, selon le protocole PCIe.

Dans cet exemple, on a représenté six ports mini SAS HD 102. Les ports mini SAS HD sont fixés sur la carte porteuse 12, en étant sertis ou soudés à travers cette dernière, par exemple selon un procédé désigné par le terme "press fit"comme représenté sur la figure 3B. Chaque port mini SAS HD comporte des broches de raccordement 102a, ces dernières s'étendant à travers la carte porteuse 12. Ainsi, chaque port mini SAS HD 102 est raccordé, de façon non amovible, à des pistes conductrices s'étendant sur la carte porteuse 12. Les pistes conductrices définissent le routage entre les embases 102 et le connecteur COM Express relié à la carte mère 11.

Chaque embase mini SAS HD 102 comporte 4 liens PCIe, un lien comportant deux paires (une paire de transmission et une paire de réception) pour effectuer respectivement une transmission de l'information et une réception de l'information. Elle peut notamment comporter :
- des connexions pour une transmission d'un signal d'horloge (1 paire) ;
- un bus de contrôle I2C (Inter-Integrated Circuit) ;
- un signal d'activation à destination de la carte d'extension (usuellement désigné par l'acronyme PS-On, PS désignant Power Supply) ;
- un signal de réveil (usuellement désigné par le terme wake) qui permet de réveiller le microprocesseur 13 à partir de la carte d'extension 31 ;
- et un signal d'initialisation (usuellement désigné par le terme reset).

Ainsi, chaque embase mini SAS HD 102 permet de former une liaison PCIe x4. L'association de deux embases permet de former une liaison PCIe x8. L'ensemble formé par les 6 embases permet de disposer de 24 liens PCIe.

Le signal de réveil se propage de la carte d'extension 31 vers l'unité centrale 10. La carte porteuse 12 assure une transmission du signal de réveil entre au moins un port mini SAS HD et la carte mère 11.

Le routage effectué sur la carte porteuse 12 permet de raccorder les paires de transmission et de réception directement au connecteur COM express 11c de la carte mère 11. Il en est de même du signal de réveil (wake), ce dernier faisant l'objet d'un routage entre le connecteur COM express de la carte mère 11 et chaque port mini SAS-HD. Le signal d'activation est issu d'un module de gestion d'alimentation 17 situé sur la carte porteuse 12.

Pour distribuer le bus de contrôle I2C sur chacun des ports mini SAS HD, la carte porteuse 12 comporte un multiplexeur I2C référencé 2M, représenté sur la figure 3A. Le multiplexeur 2M est disposé entre la carte mère 11, et plus précisément l'embase COM express, et les ports mini SAS-HD. Il adresse un bus de contrôle I2C à chaque port mini SAS-HD 102.

La carte porteuse comporte également un amplificateur du signal d'horloge 2C, s'étendant entre la carte mère et les ports mini SAS-HD, également représenté sur la figure 3A. L'amplificateur de signal d'horloge distribue un signal d'horloge à chaque port mini SAS HD 102. C'est un multiplicateur de signal d'horloge.

La carte porteuse comporte également un amplificateur de signal d'initialisation 2R, s'étendant entre la carte mère et les ports mini SAS HD, et représenté sur la figure 3A. L'amplificateur du signal d'initialisation distribue un signal d'initialisation (reset) à chaque port mini SAS HD.

La carte porteuse 12 comporte une carte 18 de gestion de la température, reliée à des thermocouples et permettant l'activation de ventilateurs 106, 116. La carte 18 est représentée sur la figure 3A. Elle est reliée à un radiateur 16, permettant une conduction de la chaleur jusqu'à une zone de ventilation s'étendant entre les ventilateurs 106 et 116, permettant la formation d'un flux d'air s'écoulant à travers l'unité centrale 10. Le radiateur 16 est représenté sur les figure 3C et 3D. Il se présente sous la forme d'une plaque formée à partir d'un matériau thermiquement conducteur, par exemple de l'aluminium. Dans cet exemple, le radiateur s'étend parallèlement à la carte mère 11 et à la carte porteuse 12, ce qui favorise la compacité de l'unité centrale 10.

La carte porteuse 12 comporte également une carte, dite carte mezzanine 19, surélevée par rapport à la carte porteuse 12 par une entretoise, et reliée à un commutateur marche/arrêt 115, ainsi qu'à des diodes électroluminescentes d'état 114. La carte mezzanine est représentée sur la figure 3D. Le commutateur marche/arrêt pilote le démarrage et l'arrêt de l'unité centrale 10.

L'unité centrale 10 comporte des autres embases de connexion plus classiques, en particulier, sur la face arrière 12a :
- deux connecteurs SATA 103, destinés à être raccordés à des périphériques de stockage, visibles sur les figures 3A, 3C et 3E;
- un connecteur de type miniFit (Molex), référencé 104 sur les figures 3A, 3C et 3E. Ce connecteur est un connecteur 24 points, et permet de reporter, au niveau du châssis 2, des connexions telles que des ports USB, un commutateur d'initialisation "Reset" et des voyants d'état.
- un connecteur d'alimentation 6 points, relié à un module d'alimentation externe, et connecté au module de gestion d'alimentation 17 de la carte porteuse 12. Ce connecteur est référencé 105 sur les figures 3A, 3C, 3D et 3E.

Afin de respecter les contraintes de compacité de l'unité centrale, et en particulier le respect d'un format 5"1/4, les ports mini SAS-HD 102 et le connecteur d'alimentation 105 sont implantés sur la première face 12.1 de la carte porteuse 12, tandis que les autres connecteurs sont disposés sur la deuxième face 12.2 de la carte porteuse 12. Cf. figure 3C et 3D.

Sur la face avant 12b de la carte porteuse 12 débouchent les connexions suivantes :
- un port Ethernet 112, visible sur les figures 3A et 3F ;
- quatre ports USB (Universal Serial Bus) 113, visibles sur les figures 3A, 3C et 3F ;
- deux ports d'affichage (Display Port) 111, représentés sur les figures 3A, 3D et 3F.

La carte porteuse 12 dispose de modules de gestion des connexions miniFit, Ethernet, USB, SATA et Display Port.

L'unité centrale 10 telle que précédemment décrite permet d'agencer différentes cartes d'extension 31 dans un châssis 2, par exemple un châssis de type 19 pouces, de hauteur 1U. C'est ce qui est représenté sur les figures 2A et 2B. Dans les exemples représentés ci-avant, l'unité centrale s'étend à l'intérieur d'un module 10s de type 5 pouces % selon la spécification SFF-8500.

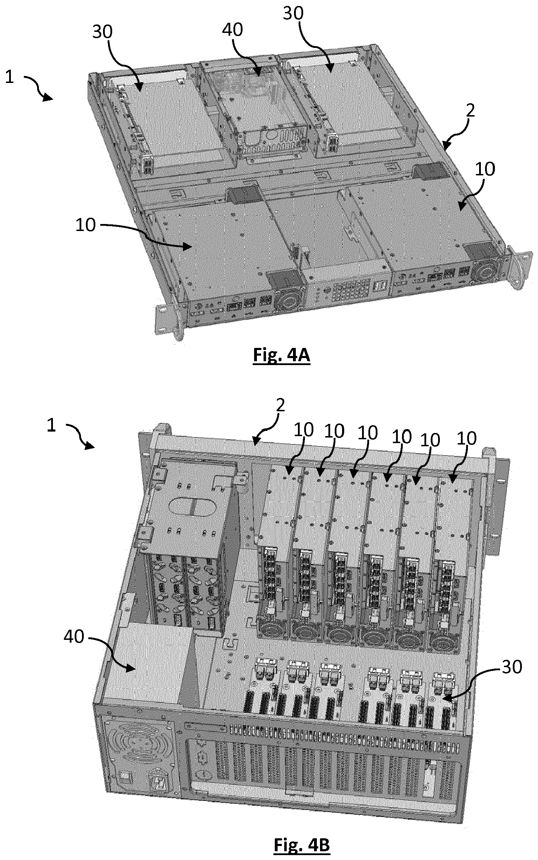

La figure 4A représente une autre configuration, comportant deux unités centrales 10 telles que précédemment décrites, et deux modules d'extension 30, disposés dans le même châssis 2. Le châssis 2 comporte également un module d'alimentation 40. Le format 5 pouces % de chaque unité centrale permet d'en disposer plusieurs dans un même châssis.

Mais l'invention ne se limite pas à une mise en oeuvre dans des châssis de type 1U. La figure 4B montre par exemple un châssis 4U, comportant six unités centrales 10 telles que précédemment décrites, ainsi que différents modules d'extension 31 et un module d'alimentation 40.

On comprend que l'invention permet de maximiser le nombre de cartes d'extension connectées à une unité centrale, et cela en respectant les contraintes liées à l'utilisation d'un châssis 2 aux dimensions normalisées.

Le domaine d'application privilégié est l'informatique professionnelle, domaine dans lequel des ordinateurs doivent être réalisés sur mesure, ce qui exige une souplesse importante dans la disposition et le nombre des cartes d'extensions à mettre en oeuvre.

## Revendications

1. Ordinateur (1), contenu dans un châssis (2), et comportant une unité centrale (10) ainsi qu'au moins une carte d'extension (31), distante de l'unité centrale, l'ordinateur étant tel que
- l'unité centrale (10) et la carte d'extension sont logées dans le châssis ;
- la carte d'extension est configurée pour assurer une interface avec un élément distant (50), situé hors du châssis (2), de façon à adresser un signal de commande à l'élément distant et/ou à acquérir un signal généré par l'élément distant ;
- l'unité centrale (10) comporte une carte porteuse (12) et une carte mère (11), reliées l'une à l'autre, la carte mère comprenant un microprocesseur (13), la carte porteuse (12) assurant une interface entre la carte mère et au moins un port d'entrée/sortie (102), disposé dans l'unité centrale, et destiné à être raccordé à la carte d'extension (31) ;
l'ordinateur étant **caractérisé en ce que** :
- la carte porteuse (12) comporte une embase de type Mini SAS HD (102), formant un port d'entrée/sortie de l'unité centrale, la carte porteuse (12) définissant un routage entre l'embase Mini SAS HD (102) et le microprocesseur (13) de la carte mère (11), de façon à autoriser une communication entre le microprocesseur (13) et la carte d'extension (31), à travers l'embase Mini SAS HD, selon un protocole PCI Express ;
- l'unité centrale (10) est reliée à la carte d'extension (31) par un câble de connexion (5), le câble de connexion étant souple et comportant une extrémité formant un connecteur de type Mini SAS HD, raccordé à l'embase Mini SAS HD de la carte porteuse (12).

2. Ordinateur (1) selon la revendication 1, dans lequel la carte porteuse (12) de l'unité centrale (10) s'étend selon un support rigide, l'embase Mini SAS HD (102) étant disposée à travers le support rigide.

3. Ordinateur (1) selon la revendication 2, dans lequel l'embase Mini SAS HD (102) présente des broches de connexions (102a), ces dernières s'étendant à travers le support rigide.

4. Ordinateur (1) selon l'une quelconque des revendications précédentes, dans lequel la carte porteuse (12) de l'unité centrale (10) comporte une pluralité d'embases de type Mini SAS HD (102), la carte porteuse (12) comportant un multiplexeur d'adressage (2M), relié d'une part au microprocesseur (13) de la carte mère (11) et d'autre part à plusieurs embases Mini SAS HD.

5. Ordinateur (1) selon l'une quelconque des revendications précédentes, dans lequel la carte porteuse (12) de l'unité centrale (10) comporte une pluralité d'embases de type Mini SAS HD (102), la carte porteuse (12) comportant un multiplicateur de signal d'horloge (2C), relié d'une part au microprocesseur (13) de la carte mère (11) et d'autre part à plusieurs embases Mini SAS HD.

6. Ordinateur (1) selon l'une quelconque des revendications précédentes, dans lequel la carte porteuse (12) de l'unité centrale (10) est apte à diriger un signal de réveil, à destination du microprocesseur (13) de la carte mère (11), entre au moins une embase Mini SAS HD (102) et la carte mère.

7. Ordinateur (1) selon l'une quelconque des revendications précédentes, dans lequel l'élément distant (50), relié à la carte d'extension (31) est choisi parmi :
- un capteur, configuré pour acquérir un signal, de telle sorte que la carte d'extension forme une carte d'acquisition du signal ;
- un actionneur, configuré pour effectuer une action pilotée par le microprocesseur (13).

8. Ordinateur (1) selon l'une quelconque des revendications précédentes, dans lequel l'unité centrale (10) comporte un ventilateur (106, 116), apte à propager un flux d'air à travers l'unité centrale (10), cette dernière comportant également un radiateur (16) en forme de plaque, s'étendant parallèlement à la carte mère (11), de façon à conduire une chaleur dégagée par cette dernière vers le flux d'air.

9. Ordinateur (1) selon l'une quelconque des revendications précédentes, dans lequel l'unité centrale (10) s'étend dans un module (10s) de type 5 pouces % selon la spécification SFF-8500

10. Ordinateur (1) selon l'une quelconque des revendications précédentes, dans lequel la carte d'extension (31) est disposée dans un module d'extension (30), ce dernier comportant une interface de connexion (20), comportant d'une part une embase Mini SAS-HD, configurée pour recevoir un connecteur mini SAS-HD du câble de connexion (5), et d'autre part une embase linéaire PCIe, dans lequel la carte d'extension (31) est apte à être insérée.

11. Ordinateur (1) selon la revendication 10, dans lequel le câble de connexion (5) reliant l'unité centrale (10) au module d'extension (30) comporte un connecteur mini SAS-HD à chacune de ses extrémités.

12. Ordinateur (1) selon l'une quelconque des revendications précédentes, dans lequel le châssis (2) est un châssis de type 19 pouces, selon la spécification IEC-60297, la hauteur du châssis (2) étant comprise entre 1U et 4U, U désignant une hauteur de 44 mm.

13. Ordinateur (1) selon l'une quelconque des revendications précédentes, dans lequel la carte porteuse (12) comporte un multiplexeur I2C (2M), pour adresser un bus de contrôle I2C à au moins une embase mini SAS-HD (102).

14. Ordinateur (1) selon l'une quelconque des revendications précédentes, dans lequel au moins une embase mini SAS HD (12) est configurée pour former une liaison PCIe x4.
